# EUROPEAN PATENT SPECIFICATION

(11) **EP 0 714 133 B1**
(45) Date of publication and mention of the grant of the patent: **06.02.2002**
(21) Application number: 94830544.6
(22) Date of filing: 24.11.1994
(51) Int. Cl.: H01L 27/115, H01L 21/8247, H01L 27/105

(54) **EEPROM integrated device with reduced body effect and twin-well manufacturing process thereof**
Integrierte EEPROM-Schaltung mit reduziertem Substrat-Effekt und Zwei-Wannen-Herstellungsverfahren hiervon
Circuit intégré de type EEPROM ayant un effet de substrat réduit et procédé à double-puits de sa fabrication

(43) Date of publication of application: 29.05.1996
(73) Proprietor: STMicroelectronics S.r.l., 20041 Agrate Brianza (Milano) (IT)
(72) Inventor: Vajana, Bruno, I-24100 Bergamo (IT); Baldi, Livio, I-20041 Agrate Brianza (Milano) (IT)
(74) Representative: Mittler, Enrico

(56) References cited:
- EP-A- 0 416 687
- EP-A- 0 421 446
- EP-A- 0 598 974
- US-A- 5 132 241

## Description

The present invention relates to a twin-well manufacturing process for an EEPROM integrated device with reduced body effect, and particularly to a single polysilicon level process.

Single polysilicon level manufacturing processes for EEPROM devices are already known in the art, and are for example described in:
- R. Cuppens et al., "An EEPROM for Microprocessors and Custom Logic", 1984 IEEE International Solid-State Circuits Conference, pags. 268-269;
- J. Tsujimoto et al., "A 5V-Only 256K CMOS EEPROM using Barrier Height Lowering Technique", 1985 Solid State Conference pag. 241;
- J. Miyamoto et al., "An Experimental 5-V-Only 256-kbit CMOS EEPROM with a High-Performance Single-Polysilicon Cell", IEEE Journal of Solid-State Circuits, vol. SC-21, No. 5, October 1986, pags. 852-859;
- EP-A-0416687.

A single polysilicon level EEPROM memory cell is comprised of a selection transistor and a floating-gate sensing transistor connected in series between a respective bit line and a common ground. A thin oxide (tunnel oxide) region is provided over the drain diffusion of the sensing transistor; the floating gate of the sensing transistor, formed from the single polysilicon layer, extends over the tunnel oxide region, and also overlaps an N type diffusion forming a control gate of the sensing transistor: hence, the single polysilicon layer is capacitively coupled, at one side, to the drain diffusion of the sensing transistor (forming a plate of the tunnel capacitor), and, at another side, to the control gate diffusion (see for example EP-A-0416687).

Such a memory cell is written and erased by means of Fowler-Nordheim tunneling of electrons through the thin oxide region, exploiting the capacitive couplings between control gate, floating gate and silicon substrate.

With respect to double polysilicon level manufacturing processes, wherein the control gate of the sensing transistor is formed from a second polysilicon layer superimposed over the first polysilicon layer forming the floating gate, the single polysilicon level process is quite easier and more reliable: in fact, the critical technological steps necessary for the definition of the superimposed polysilicon layers are avoided, and the thin oxide layer is not subjected to the high-temperature thermal treatments necessary for the growth of the interpoly dielectrics. This is a key feature of the single polysilicon level process, which makes it preferable when high memory cell densities are not the primary goal.

It is also known that advanced CMOS manufacturing processes provide for forming both N type wells and P type wells in a same semiconductor substrate, for example of the P conductivity type (twin-well processes): this in fact allows to obtain optimized P channel and N channel MOSFETs, by independently adjusting the dopant concentrations in the N type and P type wells, respectively.

Conventionally, the P type wells are formed at the early process steps in a self-aligned manner with the N type wells: as a consequence, not only the MOSFETs of the peripheral circuitry of the memory device, but also the memory cells are formed inside a well, typically of the P conductivity type (i.e. the matrix of memory cells is formed inside a large P type well). Since however the dopant concentration in the P type wells is higher than that in the P type substrate, the N type selection transistor and the N type sensing transistor experience a high body effect. This is disadvantageous, since in order to assure wide programming voltage margins for the memory cell, the selection transistor should experience as low body effect as possible, so that the programming voltage (Vpp) which is applied to its drain during the cell writing is entirely transferred to the drain of the sensing transistor without voltage drops.

Therefore, conventional twin-well manufacturing processes for EEPROM integrated devices are not optimized due to the high body effect of the N channel transistors.

A possible way to Lower the programming voltage needed to program the memory cells (i.e. the voltage to be applied to the drain of the selection transistor) calls for a reduction of the thickness of the tunnel oxide. However, thinner tunnel oxides means greater defectivity and lower manufacturing yield.

Another way to lower the programming voltage calls for increasing the capacitive coupling area. This, however, obviously implies an increase in the memory cell size, and thus in the EEPROM device die size, and is therefore disadvantageous.

EP-A-0 598 974 discloses a semiconductor integrated device having EEPROM memory cells and associated peripheral circuitry directly formed in the substrate.

In view of the state of the art described, an object of the present invention is to provide a twin-well manufacturing process for EEPROM integrated devices, particularly a single polysilicon level process, which allows to form EEPROM memory cells with reduced body effect.

According to the present invention, such object is achieved by means of a device as defined in claim 1 and a twin-well process as defined in claim 4.

Thanks to the fact that the matrix of EEPROM memory cells is formed directly in the semiconductor substrate, instead of inside a well, the EEPROM memory cells experience a reduced body effect; a higher fraction of the programming voltage Vpp applied to the drain of the selection transistor of a memory cell is thus transferred to the drain of the sensing transistor of the memory cell; lower programming voltages are thus needed to achieve similar programming conditions of the memory cells. With respect to a conventional twin-well, the process according to the present invention only provides for an additional mask (whenever such a mask is not already provided in the process flow for different purposes). The memory cell layout need not be modified.

The features of the present invention will be made more evident by the following detailed description of a particular embodiment, shown as a non-limiting example in the annexed drawing, wherein:
Figures 1 to 4 are cross-sectional views of a first substrate portion and a second substrate portion of a semiconductor substrate wherein an EEPROM integrated device is to be formed, taken at an early stage of a manufacturing process according to the present invention;
Figures 5 to 11 are cross-sectional views of an EEPROM memory cell taken at intermediate steps of the manufacturing process of the invention;
Figures 5A and 8A-11A are cross-sectional views of an N-channel and a P-channel MOSFETs at intermediate steps of the manufacturing process of the invention;
Figure 12 is a top-plan view of the EEPROM memory cell;
Figure 13 is a cross-sectional view of the EEPROM memory cell taken along line XIII-XIII in Figure 12.

A twin-well manufacturing process, particularly a single polysilicon level process, for an EEPROM integrated device according to the present invention starts with a silicon substrate 1 having a resistivity of a few Ohms per centimeter; typically, the substrate is doped with P type impurities, and its resistivity ranges from 1 to 3 Ohm per cm. A matrix of memory cells will be formed in one portion 5 of the substrate 1, whereas a peripheral logic, comprising N-channel and P-channel MOSFETs, will be formed in another portion 6 of the substrate 1.

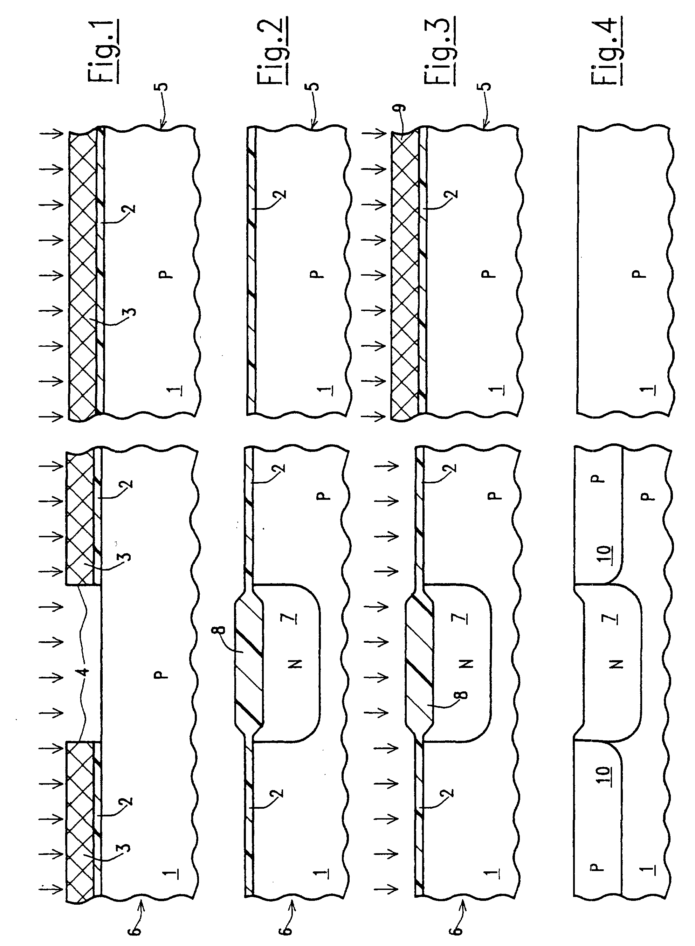

An oxide layer 2 is then formed over a surface of the substrate 1, and a nitride layer 3 is deposited over the oxide layer 2. The nitride layer 3 and the oxide layer 2 are then selectively etched to open windows 4, and an N type dopant, such as phosphorus, is implanted into the substrate in a dose of about 10¹²-10¹³ cm (Fig. 1); where the nitride layer 3 has not been removed (particularly over the portion 5 of the substrate 1), it masks the substrate 1, preventing the dopant from penetrating into the substrate 1.

The implanted dopant is then made to diffuse through the substrate 1, to form N type wells 7 about 3.5 um deep; during the thermal diffusion process, thick oxide areas 8 are formed over the surface of the substrate 1 inside the windows 4.

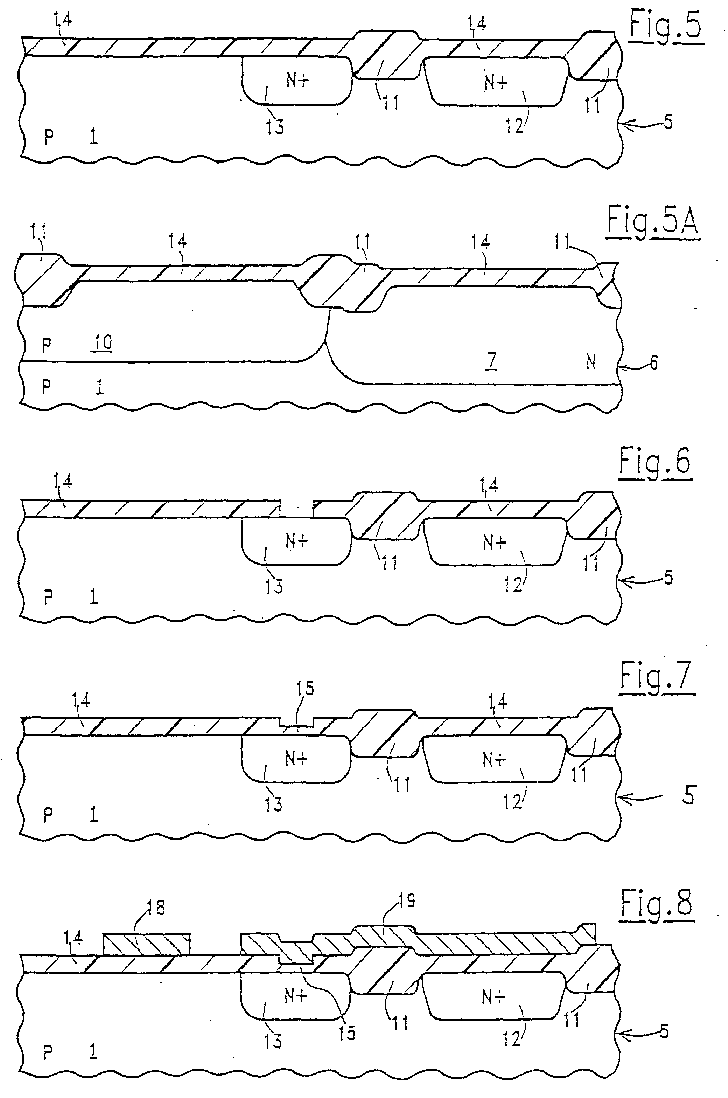

The nitride layer 3 is then completely removed, a photoresist film 9 is deposited over the oxide layers 2 and 8, and the fotoresist film 9 is then selectively removed from the portion 6 of the substrate 1 (Fig. 3).

A P type dopant, such as boron, is then implanted into the substrate 1 in a dose of about 10¹²-10¹³ cm . The thick oxide areas 8 and the photoresist film 9 prevent the dopant from penetrating into the N type wells 7 and the portion 5 of the substrate 1 wherein the memory cells are to be formed.

The implanted dopant is then made to diffuse through the substrate 1, to form P type wells 10 approximately 1.5 um deep. The photoresist layer 9, the oxide layer 2 and the thick oxide areas 8 are then completely removed from the surface of the substrate 1 (Fig. 4).

In this way, P type wells 10 are formed in a self-aligned manner with the N type wells 7. If however it is desired the P type wells 10 not be self-aligned with the N type wells 7, for example to provide a given spacing between P type and N type wells, it is possible to keep the photoresist film 9 not only over the portion 5 of the substrate 1, but also over the already-formed N type wells 7 (i.e. the photoresist film is removed only over those portions of the substrate where P type wells are to be formed). Also, it is possible to mask areas of the portion 6 of the substrate where neither N type wells, nor P type wells are to be formed.

It could also be possible, after the implantation of the N type dopant for the N type wells, to remove the nitride layer 3, deposit the photoresist film 9, selectively remove the photoresist film 9 only where P type wells are to be formed, implanting the P type dopant, and then performing a single thermal diffusion process to diffuse both the N type dopant and the P type dopant.

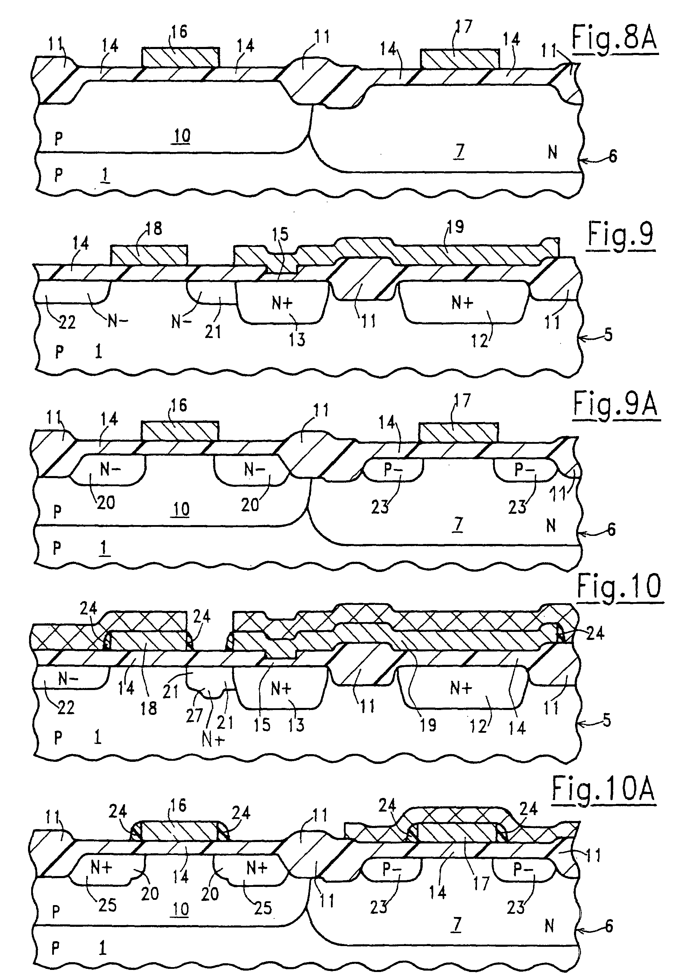

The subsequent steps provide, in a per-se known way, for the definition of active areas over the surface of the substrate 1; this involves the formation of thick field oxide areas 11 (Figs. 5 and 5A), with thickness of about 600 to 700 nm. An N type dopant, such as phosphorus, is then selectively implanted into the portion 5 of the substrate 1, in a dose of about 10¹⁵ cm⁻²; the implanted dopant is then made to diffuse through the substrate 1 to form control gate diffusions 12 and tunneling diffusions 13 for the memory cells (Fig. 5). The control gate diffusions 12 forms the so-called "rows" or "word lines" of the matrix of memory cells (not shown). A thin oxide layer 14, with thickness of about 15 to 20 nm, is then grown over the surface of the substrate 1 between the field oxide areas 11 (Figs. 5 and 5A); such oxide layer 14 will form the gate oxide of both the N channel and P channel MOSFETs which are to be formed in the portion 6 of the substrate 1, and of the memory cells. The thin oxide layer 14 is then selectively removed over the tunneling diffusions 13 (Fig. 6), and thinner tunnel oxide areas 15 are grown having a thickness of about 7 to 9 nm (Fig. 7).

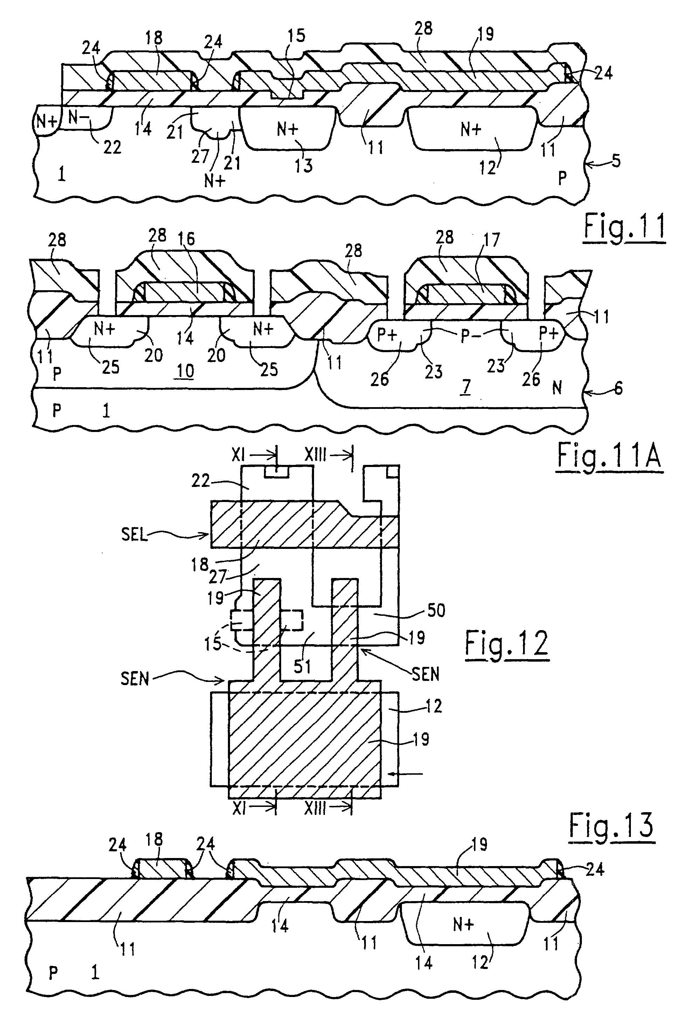

A polysilicon layer is then deposited over the whole surface of the chip and, after it has been doped with an N type dopant, it is selectively etched to form gates 16, 17 for the N channel and P channel MOSFETs (Fig. 8A), gates 18 for selection transistors SEL of the memory cells, and floating gates 19 for sensing transistors SEN of the memory cells (Figs. 8 and 12).

A low dose (10¹²-10¹³ cm⁻²) of an N type dopant, such as phosphorus, is then implanted into the substrate 1 to form lightly doped source and drain regions 20 at the sides of the gates 16 of the N channel MOSFETs (Fig. 9A), source and drain regions 21 and 22 at the sides of the gates 18 of the selection transistors (Fig. 9), and source and drain regions 50 and 51 at the sides of the control gates 19 of the sensing transistors SEN of the memory cells (Fig. 12). The N- regions thus formed have a depth of about 0.3 um.

A low dose (10¹³-10¹⁴ cm⁻²) of a P type dopant, such as boron, is then selectively implanted into the N type wells 7 to form lightly doped source and drain regions 23 at the sides of the gates 17 of the P channel transistors (Fig. 9A). The P-regions thus formed have a depth of about 0.35 um.

Sidewall oxide spacers 24 are then formed in a per-se known way around the edges of the polysilicon gates 16, 17, 18 and 19 (Figs. 10, 10A and 13).

A high dose (10¹⁵-10¹⁶ cm⁻²) of an N type dopant, such as arsenic, is selectively implanted into the source and drain regions 20 of the N channel transistors to form heavily doped source and drain regions 25 (Fig. 10A), into the source region 21 of the selection transistors to form a heavily doped source region 27 (Fig. 10) and into the source and drain regions 50, 51 of the sensing transistors SEN.

Similarly, a high dose (10¹⁵-10¹⁶ cm⁻²) of a P type dopant is implanted into the source and drain regions 23 of the P channel transistors to form heavily doped source and drain regions 26 (Fig. 11A).

An insulating material layer 28 is deposited over the entire surface of the chip, and it is selectively removed, together with portions of the oxide layer 14, to open contact windows to the source and drain regions 25 and 26 of the N channel and P channel transistors, the drain region 22 of the selection transistors SEL of the memory cells (Figs. 11 and 11A) (which are to be contacted by a metal, not shown, forming a so-called "column" or "bit line" of the memory matrix), and the source regions of the sensing transistors SEN (which are to be connected to a common ground).

The process continues in a conventional way with the definition of metal interconnections and with the deposition of a passivating material over the entire surface of the chip.

As appears from Figures 11-12, the single polysilicon level EEPROM memory cells formed by means of the process of the present invention are similar from the layout point of view to the EEPROM memory cells formed by means of conventional twin-well, single polysilicon level processes; since, however, the memory cells are formed directly in the substrate 1, and not in a P type well, and since the doping level of the substrate 1 is lower than that of P wells, the selection transistors SEL experience a low body effect; thus, the programming voltage applied to the drain 22 of the selection transistors SEL is transferred almost integrally to their sources 27, and thus to the tunneling diffusions 13 of the sensing transistors SEN.

As an alternative, the P type wells could be formed after the thick field oxide areas 11 have been formed: the photoresist film 9 is deposited and selectively etched to mask the N type wells and the memory cells, but is also removed over the field oxide areas 11 in the memory matrix area (portion 5) and in the portion 6 where high voltage transistors are to be integrated. A P type dopant is then implanted at a relatively high energy, so that the dopant penetrates in the substrate under the exposed field oxide areas, in order to guarantee a suitable field isolation which prevents parasitic transistors from being formed.

## Claims

1. EEPROM integrated device comprising a plurality of EEPROM memory cells, first-conductivity-type-channel MOSFETs and second-conductivity-type-channel MOSFETs which are respectively formed in second-conductivity-type wells (10) and first-conductivity-type wells (7), the first- and second-conductivity-type wells (7,10) being formed in a first portion (6) of a semiconductor substrate (1), **characterized in that** said EEPROM memory cells are formed inside a second portion (6) of the substrate (1) in which no wells are formed, each EEPROM memory cell comprising a selection transistor (SEL) and a floating-gate sensing transistor (SEN) connected in series, the floating-gate sensing transistor (SEN) comprising a polysilicon floating gate (19) capacitively coupled through a gate oxide layer (14) to a control gate diffusion (12) of the first conductivity type and, through a thin tunnel oxide area (15), to a tunneling diffusion (13) of the first conductivity type connected to a source diffusion (21,27) of the selection transistor (SEL).

2. EEPROM integrated device according to claim 1, **characterized in that** said semiconductor substrate (1) is of the second conductivity type.

3. EEPROM integrated device according to claim 1, **characterized in that** said first conductivity type is the N type, and said second conductivity type is the P type.

4. Twin-well manufacturing process of an EEPROM integrated device as defined in claim 1, **characterized by** comprising the steps of:
a) selectively forming at least one first-conductivity-type well (7) in a first substrate portion (6) of a semiconductor substrate (1);
b) forming in said first substrate portion (6) second-conductivity-type wells (10), outside said first-conductivity-type well (7);
c) forming in said at least one first-conductivity-type well (7) and in said second-conductivity-type-wells (10) second-conductivity-type-channel MOSFETs and first-conductivity-type-channel MOSFETs, respectively, and simultaneously forming a plurality of EEPROM memory cells in a second substrate portion (5) in which no wells have been formed.

5. Process according to claim 4, **characterized in that** step b) is accomplished by masking said second substrate portion (5) and introducing a first dopant of a second conductivity type in said first substrate portion (6) outside said first-conductivity-type well (7).

6. Process according to claim 5, **characterized in that** step a) is accomplished by forming an oxide layer (2) over the substrate (1), forming a nitride layer (3) over the oxide layer (2), selectively removing the nitride layer (3) over the first substrate portion (6) to open at least one window (4), implanting a second dopant of the first conductivity type into the first substrate portion (6) through said at least one window (4), diffusing said second dopant through said first substrate portion (6) to form said at least one first-conductivity-type well (7), removing the nitride layer (3), and **in that** step b) is accomplished by forming a photoresist layer (9) over said oxide layer (2), completely removing the photoresist layer (9) over said first substrate portion (6), leaving the photoresist layer (9) only over the second substrate portion (5), implanting the first dopant of the second conductivity type into the first substrate portion (6), and diffusing said first dopant through said first substrate portion (6) to form said second-conductivity type wells (10) in a self-aligned manner with said at least one first-conductivity-type well (7).

7. Process according to claim 5, **characterized in that** step a) is accomplished by forming an oxide layer (2) over the substrate (1), forming a nitride layer (3) over the oxide layer (2), selectively removing the nitride layer (3) over the first substrate portion (6) to open at least one window (4), implanting a second dopant of the first conductivity type into the first substrate portion (6) through said at least one window (4), diffusing said second dopant trhough said first substrate portion (6) to form said at least one first-conductivity-type well (7), removing the nitride layer (3), and **in that** step b) is accomplished by forming a photoresist layer (9) over said oxide layer (2), selectively removing the photoresist layer (9) over said first substrate portion (6), leaving the photoresist layer (9) at least over said first-conductivity-type well (7) and over the second substrate portion (5), implanting the first dopant of the second conductivity into the first substrate portion (6), and diffusing said first dopant through said first substrate portion (6) to form said second conductivity type wells (10).

8. Process according to claim 5 or 6, **characterized in that** said semiconductor substrate (1) is of the second conductivity type.

9. Process according to claim 8, **characterized in that** step c) provides for:
d) defining active areas at the surface of the first and second substrate portions (6,5);
e) forming a thin gate oxide layer (14) inside said active areas;
f) selectively implanting and diffusing into the second substrate portion (5) a third dopant of the first conductivity type to form control gate diffusions (12) and tunneling diffusions (13) for the EEPROM memory cells;
g) forming over said tunneling diffusions (13) thin tunnel oxide areas (15);
h) depositing and selectively removing a polysilicon layer for forming polysilicon gates (16,17) for the first- and second-conductivity-type-channel MOSFETs respectively over said second- and first-conductivity-type wells (10,7), and, over said second substrate portion (5), polysilicon gates (18) for selection transistors (SEL) of the EEPROM memory cells and polysilicon floating gates (19) for sensing transistors (SEN) of the EEPROM memory cells;
i) selectively implanting dopants of the first conductivity type into said second-conductivity-type wells (10) to form source and drain regions (20,25) for the first-conductivity-type-channel MOSFETs, and into said second substrate portion (5) to form source and drain regions (21,22,27) of the selection transistors (SEL) of the EEPROM memory cell, and source and drain regions (50,51) of the sensing transistors (SEN) of the EEPROM memory cells.

10. Process according to claim 5, **characterized in that** step a) is accomplished by forming an oxide layer (2) over the substrate (1), forming a nitride layer (3) over the oxide layer (2), selectively removing the nitride layer (3) over the first substrate portion (6) to open at least one window (4), implanting a second dopant of the first conductivity type into the first substrate portion (6) through said at least one window (4), diffusing said second dopant through said first substrate portion (6) to form said at least one first-conductivity-type well (7), removing the nitride layer (3), and **in that** step b) is accomplished by selectively farming thick field oxide areas (11) at the surface of the first and second substrate portions (6,5) to define active areas between said field oxide areas (11), forming a photoresist layer (9) over the active areas and over the field oxide areas (11), selectively removing the photoresist layer (9) leaving it at least over the active areas in the second substrate portion (5) and over said at least one first-conductivity-type well (7), implanting the first dopant of the second conductivity type at an energy sufficiently high to allow the dopant penetrate in the substrate under the field oxide areas (11) not covered by the photoresist layer (9), diffusing the first dopant to form said second-conductivity-type wells (10), the process further providing for:
d) forming a thin gate oxide layer (14) inside said active areas;
e) selectively implanting and diffusing into the second substrate portion (5) a third dopant of the first conductivity type to form control gate diffusions (12) and tunneling diffusions (13) for the EEPROM memory cells;
f) forming over said tunneling diffusions (13) thin tunnel oxide areas (15);
g) depositing and selectively removing a polysilicon layer for forming polysilicon gates (16,17) for the first- and second-conductivity-type-channel MOSFETs respectively over said second- and first-conductivity-type wells (10,7), and, over said second substrate portion (5), polysilicon gates (18) for selection transistors (SEL) of the EEPROM memory cells and polysilicon floating gates (19) for sensing transistors (SEN) of the EEPROM memory cells;
h) selectively implanting dopants of the first conductivity type into said second-conductivity-type wells (10) to form source and drain regions (20,25) for the first-conductivity-type-channel MOSFETs, and into said second substrate portion (5) to form source and drain regions (21,22,27) of the selection transistors (SEL) of the EEPROM memory cell, and source and drain regions (50,51) of the sensing transistors (SEN) of the EEPROM memory cells.

11. Process according to anyone of the preceding claims, **characterized in that** said first conductivity type is the N type, and said second conductivity type is the P type.

## Patentansprüche

1. Integrierte EEPROM - Vorrichtung mit einer Mehrzahl von EEPROM - Speicherzellen,
MOSFETS mit Kanal vom ersten Leitungstyp, MOSFETS mit Kanal vom zweiten Leitungstyp, die in Wannen vom zweiten Leitungstyp (10) bzw. in Wannen vom ersten Leitungstyp (7) gebildet sind, wobei die Wannen vom ersten und zweiten Leitungstyp (7, 10) in einem ersten Abschnitte (6) eines Halbleitersubstrates (1) gebildet sind,
**dadurch gekennzeichnet,**
**daß** die EEPROM - Speicherzellen innerhalb eines zweiten Abschnittes (6) des Substrates (1) gebildet sind, in dem keine Wannen gebildet sind,
wobei jede EEPROM - Speicherzelle einen Ansteuerungstransistor (SEL) und einen Abtasttransistor mit schwebendem Gate (SEN) aufweist, die in Reihe geschaltet sind,
der Abtasttransistor mit schwebendem Gate (SEN) ein schwebendes Polysiliziumgate (19) aufweist, das kapazitiv durch eine Gateoxidschicht (14) mit einer Steuergatediffusion (12) des ersten Leitungstypes und durch ein dünnes Tunneloxidgebiet (15) mit einer Tunneldiffusion (13) des ersten Leitungstypes gekoppelt ist, die mit einer Sourcediffusion (21, 27) des Ansteuertransistor (SEL) verbunden ist.

2. Integrierte EEPROM - Vorrichtung nach Anspruch 1,
**dadurch gekennzeichnet,**
**daß** das Halbleitersubstrat (1) vom zweiten Leitungstyp ist.

3. Integrierte EEPROM - Vorrichtung nach Anspruch 1 **dadurch gekennzeichnet, daß** der erste Leitungstyp der N-Typ ist und das der zweite Leitungstyp der P-Typ ist.

4. Zwillingswannenherstellungsprozess einer integrierten EEPROM - Vorrichtung, wie sie in Anspruch 1 definiert ist, **gekennzeichnet durch** die Schritte:
a) selektives Bilden von mindestens einer Wanne vom ersten Leitungstyp (7) in einem ersten Substratabschnitt (6) eines Halbleitersubstrates (1);
b) Bilden von Wannen vom zweiten Leitungstyp (10) in dem ersten Substratabschnitt (6) außerhalb der Wanne vom ersten Leitungstyp (7);
c) Bilden in der mindestens einen Wanne vom ersten Leitungstyp (7) und in den Wannen vom zweiten Leitungstyp (10) von MOSFETS mit Kanal vom zweiten Leitungstyp bzw. von MOSFETS mit Kanal vom ersten Leitungstyp und simultanes Bilden einer Mehrzahl von EEPROM - Speicherzellen in einem zweiten Substratabschnitt (5), in dem keine Wannen gebildet worden sind.

5. Prozess nach Anspruch 4,
**dadurch gekennzeichnet, daß** der Schritt b) erzielt wird durch Maskieren des zweiten Substratabschnittes (5) und Einführen eines ersten Dotiermittels eines zweiten Leitungstypes in den ersten Substratabschnitt (6) außerhalb der Wanne vom ersten Leitungstyp (7).

6. Prozess nach Anspruch 5,
**dadurch gekennzeichnet, daß** der Schritt a) erzielt wird durch Bilden einer Oxidschicht (2) über dem Substrat (1), Bilden einer Nitridschicht (3) über der Oxidschicht (2), selektives Entfernen der Nitridschicht (3) über dem ersten Substratabschnitt (6) zum Öffnen von mindestens einem Fenster (4),
Implantieren eines zweiten Dotiermittels des ersten Leitungstypes in den ersten Substratabschnitt (6) durch das mindestens eine Fenster (4), Diffundieren des zweiten Dotiermittels durch den ersten Substratabschnitt (6) zum Bilden der mindestens einen Wanne vom ersten Leitungstyp (7), Entfernen der Nitridschicht (3),
und daß der Schritt b) erzielt wird durch Bilden einer Fotolackschicht (9) über der Oxidschicht (2), vollständiges Entfernen der Fotolackschicht (9) über dem ersten Substratabschnitt (6), Belassen der Fotolackschicht (9) nur über den zweiten Substratabschnitt (5), Implantieren des ersten Dotiermittels des zweiten Leitungstypes in den ersten Substratabschnittes (6) und Diffundieren des ersten Dotiermittels durch den ersten Substratabschnittes (6) zum Bilden der Wannen vom zweiten Leitungstyp (10) in einer selbstausgerichteten Weise mit der mindestens einen Wanne vom ersten Leitungstyp (7).

7. Prozess nach Anspruch 5,
**dadurch gekennzeichnet, daß** der Schritt a) erzielt wird durch Bilden einer Nitridschicht (3) über dem Substratabschnitt (6) zum Öffnen von mindestens einem Fenster (4), Implantieren eines zweiten Dotiermittels des ersten Leitungstypes in den ersten Substratabschnitt (6) durch das mindestens eine Fenster (4), Diffundieren des zweiten Dotiermittels durch den ersten Substratabschnitt (6) zum Bilden der mindestens einen Wanne vom ersten Leitungstyp (7), Entfernen der Nitridschicht (3) und
daß der Schritt b) erzielt wird durch Bilden einer Fotolackschicht (9) über der Oxidschicht (2), selektives Entfernen der Fotolackschicht (9) über dem ersten Substratabschnitt (6), Belassen der Fotolackschicht (9) mindestens über der Wanne vom ersten Leitungstyp (7) und über dem zweiten Substratabschnitt (5), Implantieren des ersten
Dotiermittels des zweiten Leitungstypes in den ersten Substratabschnitt (6) und Diffundieren des Dotiermittels durch den ersten Substratabschnitt (6) zum Bilden der Wannen vom zweiten Leitungstyp (10).

8. Prozess nach Anspruch 5 oder 6,
**dadurch gekennzeichnet, daß** das Halbleitersubstrat (1) vom zweiten Leitungstyp ist.

9. Prozess nach Anspruch 8, **dadurch gekennzeichnet, daß** der Schritt c) vorsieht:
d) Definieren von aktiven Gebieten an der Oberfläche des ersten und zweiten Substratabschnittes (6, 5);
e) Bilden einer dünnen Gateoxidschicht (14) innerhalb der aktiven Gebiete;
f) Selektives Implantieren und Diffundieren eines dritten Dotier-mittels des ersten Leitungstypes in den zweiten Substrat-abschnitt (5) zum Bilden einer Steuergatediffusion (12) und Tunneldiffusionen (13) für die EEPROM - Speicherzellen;
g) Bilden von dünnen Tunneloxidgebieten (15) über den Tunneldiffusionen (13);
h) Abscheiden und selektives Entfernen einer Polysiliziumschicht zum Bilden von Polisiliziumgates (16, 17) für die MOSFETS mit Kanal vom ersten und zweiten Leitungstyp entsprechend über den Wannen vom zweiten und ersten Leitungstyp (10, 7), und über dem zweiten Substratabschnitt (5) von Polisiliziumgates (18) für Ansteuerungstransistoren (SEL) der EEPROM - Speicherzellen und von schwebenden Polisiliziumgates (19) für Abtast-transistoren (SEN) der EEPROM - Speicherzellen;
i) Selektives Implantieren von Dotiermittel des ersten Leitungstypes in die Wannen vom zweiten Leitungstyp (10) zum Bilden von Source-/Drainbereichen (20, 25) für die MOSFETS mit Kanal vom ersten Leitungstyp und in den zweiten Substratabschnitt (5) zum Bilden von Source-/Drainbereichen (21, 22, 27) der Ansteuerungstransistoren (SEL) der EEPROM - Speicherzelle und von Source-/Drainbereichen (50, 51) der Abtasttransistoren (SEN) der EEPROM - Speicherzellen.

10. Prozess nach Anspruch 5,
**dadurch gekennzeichnet, daß** der Schritt a) erzielt wird durch Bilden einer Oxidschicht (2) über dem Substrat (1), Bilden einer Nitridschicht (3) über der Oxidschicht (2), selektives Entfernen der Nitridschicht (3) über dem ersten Substratabschnitt (6) zum Öffnen von mindestens einem Fenster (4), Implantieren eines zweiten Dotiermittels des ersten Leitungstypes in den ersten Substratabschnitt (6) durch das mindestens eine Fenster (4), Diffundieren des zweiten Dotiermittels durch den ersten Substratabschnitt (6) zum Bilden der mindestens einen Wanne vom ersten Leitungstyp (7), Entfernen der Nitridschicht(3), und daß der Schritt b) erzielt wird durch selektives Bilden von dicken Feldoxidgebieten (11) an der Oberfläche des ersten und des zweiten Substratabschnittes (6, 5) zum Definieren von aktiven Gebieten zwischen den Feldoxidgebieten (11), Bilden einer Fotolackschicht (9) über den aktiven Gebieten und über den Feldoxidgebieten (11), selektives Entfernen der Fotolackschicht (9), wobei sie mindestens über den aktiven Gebieten den zweiten Substratabschnitt (5) und über der mindestens einer Wanne vom ersten Leitungstyp (7) belassen wird, Implantieren des ersten Dotiermittels des zweiten Leitungstypes mit einer Energie ausreichend hoch zum Ermöglichen, daß das Dotiermittel in das Substrat unter den Feldoxidgebieten (11) eindringt, die nicht von der Fotolackschicht (9) bedeckt sind, Diffundieren des ersten Dotiermittels zum Bilden der Wannen von zweiten Leitungstypen (10), wobei der Prozess weiter vorsieht:
d) Bilden einer dünnen Gateoxidschicht (14) innerhalb der aktiven Gebiete;
e) Selektives Implantieren und Diffundieren eines dritten Dotiermittels des ersten Leitungstypes in den zweiten Substratabschnitt (5) zum Bilden von Steuergatediffusionen und Tunneldiffusionen (13) für die EEPROM - Speicherzellen;
f) Bilden von dünnen Tunneloxidgebieten (15) über den Tunneldifusionen (13);
g) Abscheiden und selektives Entfernen einer Polysiliziumschicht zum Bilden von Polysiliziumgates (16, 17) für die MOSFETS mit Kanal vom ersten und vom zweiten Leitungstyp entsprechend über den Wannen vom zweiten und vom ersten Leitungstyp (10, 7), und über dem zweiten Substratabschnitt (5) von Polysiliziumgates (18) für Ansteuerungstransistoren (SEL) der EEPROM - Speicherzellen und von schwebenden Polysiliziumgates (19) für Abtasttransistoren (SEN) der EEPROM - Speicherzellen;
h) Selektives Implantieren von Dotiermittel des ersten Leitungstypes in die Wannen von zweiten Leitungtyp (10) zum Bilden von Source-/Drainbereichen (20, 25) für die MOSFETS mit Kanal vom ersten Leitungstyp und in den zweiten Substratabschnitt (5) zum Bilden von Source-/Drainbereichen (21, 22, 27) für die Ansteuerungstransistoren (SEL) der EEPROM - Speicherzelle und von Source-/Drainbereichen (50, 51) der Abtasttransistoren (SEN) der EEPROM - Speicherzellen.

11. Prozess nach einem der vorgehenden Ansprüche,
**dadurch gekennzeichnet, daß** der erste Leitungstyp der N-Typ ist und das der zweite Leitungstyp der P-Typ ist.

## Revendications

1. Dispositif intégré EEPROM comprenant une pluralité de cellules mémoire EEPROM, des transistors MOS à canal du premier type de conductivité et des transistors MOS à canal du second type de conductivité qui sont respectivement formés dans des caissons du second type de conductivité (10) et des caissons du premier type de conductivité (7), les caissons des premier et second types de conductivité (7, 10) étant formés dans une première partie (6) d'un substrat semiconducteur (1), **caractérisé en ce que** les cellules mémoire EEPROM sont formées à l'intérieur d'une seconde partie (6) du substrat (1) dans laquelle aucun caisson n'est formé, chaque cellule mémoire EEPROM comprenant un transistor de sélection (SEL) et un transistor de lecture à grille flottante (SEN) connectés en série, le transistor de lecture à grille flottante (SEN) comprenant une grille flottante en silicium polycristallin (19) couplée capacitivement par une couche d'oxyde de grille (14) à une diffusion de grille de commande (12) du premier type de conductivité et, par une zone mince d'oxyde tunnel (15), à une diffusion tunnel (13) du premier type de conductivité connectée à une diffusion de source (21, 27) du transistor de sélection (SEL).

2. Dispositif intégré EEPROM selon la revendication 1, **caractérisé en ce que** le substrat semiconducteur (1) est du second type de conductivité.

3. Dispositif intégré EEPROM selon la revendication 1, **caractérisé en ce que** le premier type de conductivité est le type N et le second type de conductivité est le type P.

4. Procédé de fabrication de caissons jumelés d'un dispositif intégré EEPROM selon la revendication 1, **caractérisé en ce qu'**il comprend les étapes suivantes :
a) former sélectivement au moins un caisson (7) d'un premier type de conductivité dans une première partie (6) d'un substrat semiconducteur (1) ;
b) former dans la première partie de substrat (6) des caissons (10) du second type de conductivité, à l'extérieur du caisson (7) du premier type de conductivité ;
c) former dans ledit au moins un caisson (7) du premier type de conductivité et dans les caissons (10) du second type de conductivité des transistors MOS à canal du second type de conductivité et des transistors MOS à canal du premier type de conductivité, respectivement, et former simultanément une pluralité de cellules mémoire EEPROM dans une seconde partie de substrat (5) dans laquelle aucun caisson n'a été formé.

5. Procédé selon la revendication 4, **caractérisé en ce que** l'étape b) est réalisée en masquant la seconde partie de substrat (5) et en introduisant un premier dopant du second type de conductivité dans la première partie de substrat (6), à l'extérieur du caisson (7) du premier type de conductivité.

6. Procédé selon la revendication 5, **caractérisé en ce que** l'étape a) est réalisée en formant une couche d'oxyde (2) sur le substrat (1), en formant une couche de nitrure (3) sur la couche d'oxyde (2), en enlevant sélectivement la couche de nitrure (3) sur la première partie de substrat (6) pour ouvrir au moins une fenêtre (4), en implantant un second dopant du premier type de conductivité dans la première partie de substrat (6) à travers ladite au moins une fenêtre (4), en faisant diffuser le second dopant dans la première partie de substrat (6) pour former ledit au moins un caisson du premier type de conductivité (7), en enlevant la couche de nitrure (3), et **en ce que** l'étape b) est réalisée en formant une couche de photorésine (9) au dessus de la couche d'oxyde (2), en enlevant complètement la couche de photorésine (9) sur la première partie de substrat (6), en laissant en place la couche de photorésine (9) seulement au dessus de la seconde partie de substrat (5), en implantant le premier dopant du second type de conductivité dans la première partie de substrat (6), et en faisant diffuser le premier dopant dans la première partie de substrat (6) pour former les caissons (10) du second type de conductivité de façon auto-alignée avec au moins un caisson (7) du premier type de conductivité.

7. Procédé selon la revendication 5, **caractérisé en ce que** l'étape a) est réalisée en formant une couche d'oxyde (2) sur le substrat (1), en formant une couche de nitrure (3) sur la couche d'oxyde (2), en enlevant sélectivement la couche de nitrure (3) sur la première partie de substrat (6) pour ouvrir au moins une fenêtre (4), en implantant un second dopant du premier type de conductivité dans la première de substrat (6) à travers ladite au moins une fenêtre (4), en faisant diffuser le second dopant dans la première partie de substrat (6) pour former ledit au moins un caisson du premier type de conductivité (7), en enlevant la couche de nitrure (3), et **en ce que** l'étape b) est réalisée en formant une couche de photorésine (9) au dessus de la couche d'oxyde (2), en enlevant sélectivement la couche de photorésine (9) au dessus de la première partie de substrat (6), en laissant en place la couche de photorésine (9) au dessus au moins du caisson (7) du premier type de conductivité et au dessus de la seconde partie de substrat (5), en implantant le premier dopant du second type de conductivité dans la première partie de substrat (6), et en faisant diffuser le premier dopant à travers la première partie de substrat (6) pour former les caissons (10) du second type de conductivité.

8. Procédé selon la revendication 5 ou 6, **caractérisé en ce que** le substrat semiconducteur (1) est du second type de conductivité.

9. Procédé selon la revendication 8, **caractérisé en ce que** l'étape c) comporte :
d) définir des zones actives à la surface des première et seconde parties de substrat (6, 5) ;
e) former une couche mince d'oxyde de grille (14) dans les zones actives ;
f) implanter sélectivement et faire diffuser dans la seconde partie de substrat (5) un troisième dopant du premier type de conductivité pour former des diffusions de grille de commande (12) et des diffusions tunnel (13) pour les cellules mémoire EEPROM ;
g) former au dessus des diffusions tunnel (13) des zones minces d'oxyde tunnel (15) ;
h) déposer et enlever sélectivement une couche de silicium polycristallin pour former des grilles en silicium polycristallin (16, 17) pour les transistors MOS à canal des premier et second types de conductivité, respectivement au dessus des caissons des second et premier types de conductivité (10, 7) et, au dessus de la seconde partie de substrat (5), des grilles de silicium polycristallin (18) pour des transistors de sélection (SEL) des cellules mémoire EEPROM et des grilles flottantes de silicium polycristallin (19) pour des transistors de lecture (SEN) des cellules mémoire EEPROM ;
i) implanter sélectivement des dopants du premier type de conductivité dans les caissons du second type de conductivité (10) pour former des régions de source et de drain (20, 25) pour les transistors MOS à canal du premier type de conductivité, et dans la seconde partie de substrat (5) pour former des régions de source et de drain (21, 22, 27) des transistors de sélection (SEL) des cellules mémoire EEPROM et des régions de source et de drain (50, 51) des transistors de lecture (SEN) des cellules mémoire EEPROM.

10. Procédé selon la revendication 5, **caractérisé en ce que** l'étape a) est réalisée en formant une couche d'oxyde (2) sur le substrat (1), en formant une couche de nitrure (3) sur la couche d'oxyde (2), en enlevant sélectivement la couche de nitrure (3) sur la première partie de substrat (6) pour ouvrir au moins une fenêtre (4), en implantant un second dopant du premier type de conductivité dans la première partie de substrat (6) à travers ladite au moins une fenêtre (4), en faisant diffuser le second dopant dans la première partie de substrat (6) pour former ledit au moins un caisson du premier type de conductivité (7), en enlevant la couche de nitrure (3), et **en ce que** l'étape b) est réalisée en formant sélectivement des zones épaisses d'oxyde de champ (11) à la surface des première et seconde parties de substrat (6, 5) pour définir des zones actives entre les zones d'oxyde de champ (11), en formant une couche de photorésine (9) sur les zones actives et au dessus des zones d'oxyde de champ (11), en enlevant sélectivement la couche de photorésine (9) pour la laisser en place au moins au dessus des zones actives dans la seconde partie de substrat (5) et au dessus dudit au moins un caisson du premier type de conductivité (7), en implantant le premier dopant du second type de conductivité à une énergie suffisante pour permettre au dopant de pénétrer dans le substrat sous les zones d'oxyde de champ (11) non recouvertes de la couche de photorésine (9), en faisant diffuser le premier dopant pour former les caissons du second type de conductivité (10), le procédé comprenant en outre les étapes suivantes :
d) former une couche mince d'oxyde de grille (14) dans les zones actives ;
e) implanter sélectivement et faire diffuser dans la seconde partie de substrat (5) un troisième dopant du premier type de conductivité pour former des diffusions de grille de commande (12) et des diffusions tunnel (13) pour les cellules mémoire EEPROM ;
f) former au dessus des diffusions tunnel (13) des zones minces d'oxyde tunnel (15) ;
g) déposer et enlever sélectivement une couche de silicium polycristallin pour former des grilles de silicium polycristallin (16, 17) pour les transistors MOS du premier et du second type de conductivité respectivement au dessus des caissons du second et du premier type de conductivité (10, 17), et au dessus de la seconde partie de substrat (5) des grilles de silicium polycristallin (18) pour des transistors de sélection (SEL) des cellules mémoire EEPROM et des grilles flottantes de silicium polycristallin (19) pour des transistors de lecture (SEN) des cellules mémoire EEPROM ;
h) implanter sélectivement des dopants du premier type de conductivité dans les caissons du second type de conductivité (10) pour former des régions de source et de drain (20, 25) pour les transistors MOS à canal du premier type de conductivité, et dans la seconde partie de substrat (5) pour former des régions de source et de drain (21, 22, 27) des transistors de sélection (SEL) de cellules mémoire EEPROM et des régions de source et de drain (50, 51) des transistors de lecture (SEN) des cellules mémoire EEPROM.

11. Procédé selon l'une quelconque des revendications précédentes, **caractérisé en ce que** le premier type de conductivité est le type N et le second type de conductivité est le type P.
